# EUROPEAN PATENT APPLICATION

(11) **EP 4 776 376 A1**
(43) Date of publication of application: **15.07.2026**
(21) Application number: 24862491.8
(22) Date of filing: 05.08.2024
(51) Int. Cl.: H01M 10/42, H01M 10/48, H02J 7/00

(54) **BATTERY UNIT**

(30) Priority: 04.09.2023 JP 2023142979
(71) Applicant: DENSO CORPORATION, Kariya-city, Aichi 448-8661 (JP)
(72) Inventor: Nishiguchi, Yoshitaka, Kariya-city, Aichi 448-8661 (JP); Tanaka, Ken, Kariya-city, Aichi 448-8661 (JP); Takada, Satoshi, Kariya-city, Aichi 448-8661 (JP)
(74) Representative: Winter, Brandl - Partnerschaft mbB
(86) International application number: PCT/JP2024/027887
(87) International publication number: WO 2025/052837

(57) **Abstract**

A battery unit (10) includes a battery module (11), a monitoring unit (31, 32, 81) that acquires, as primary monitoring information, a detection result obtained by a detection unit (41 to 43) that detects a state of the battery module, and a control unit (33, 82) that receives the primary monitoring information from the monitoring unit and calculates secondary monitoring information by arithmetic processing based on the primary monitoring information. The monitoring unit includes a storage unit (32a, 81a) in which history information that is a history of at least one of the primary monitoring information and the secondary monitoring information is stored, and the control unit is detachable from an assembly (SA, SB) including the battery module and the monitoring unit.

## Description

### CROSS REFERENCE TO RELATED APPLICATION

This application is based on Japanese Patent Application No. 2023-142979 filed on September 4, 2023, the contents of which are incorporated herein by reference.

### TECHNICAL FIELD

The disclosure in this description relates to a battery unit.

### BACKGROUND ART

From the viewpoint of the circular economy of batteries, it is desirable that batteries that have finished their primary use in vehicles or the like be reused rather than immediately discarded. Conventionally, various prior arts regarding the reuse of batteries have been proposed (for example, see Patent Literature 1). Generally, a battery mounted on a vehicle or the like is configured as a battery unit in which a battery module and a battery monitoring device are integrated, and the battery monitoring device sequentially monitors voltage, current, temperature, and the like as the state of the battery module. Based on the information such as voltage, current, and temperature, calculation of SOC and SOH of the battery module and charge/discharge control of the battery module are performed. Note that the battery unit is also referred to as a battery pack, and the battery monitoring device is also referred to as a BMS (Battery Management System).

### PRIOR ART LITERATURE

### PATENT LITERATURE

Patent Literature 1: JP 5500252 B2

### SUMMARY OF INVENTION

In order to reduce battery costs related to reuse, it is desirable to reuse not only the battery module but also the battery monitoring device. In this case, by using battery information acquired during primary use at the time of battery reuse, it becomes possible to reuse the battery while taking into account the usage status of the battery module during primary use. However, if the battery unit including the battery monitoring device is reused as it is, there is a concern that information originally desired to be prevented from external leakage is used together with the battery module at the time of reuse, substantially resulting in leakage of information such as maker know-how.

The present disclosure has been made in view of the above circumstances, and an object thereof is to provide a battery unit capable of appropriately performing reuse of a battery module.

The present disclosure is a battery unit that includes:
a battery module;
a monitoring unit configured to acquire, as primary monitoring information, a detection result obtained by a detection unit configured to detect a state of the battery module; and
a control unit configured to receive the primary monitoring information from the monitoring unit and configured to calculate secondary monitoring information by arithmetic processing based on the primary monitoring information, and in which
the monitoring unit includes a storage unit in which history information indicative of a history of at least one of the primary monitoring information and the secondary monitoring information is stored, and
the control unit is configured to be detachable from an assembly including the battery module and the monitoring unit.

In the battery unit having the above configuration, the monitoring unit acquires the state of the battery module detected by the detection unit as the primary monitoring information. In addition, the control unit calculates the secondary monitoring information by the arithmetic processing based on the primary monitoring information received from the monitoring unit. Note that when the battery module is composed of a plurality of battery cells, the state of each battery cell may be detected by the detection unit and acquired as the primary monitoring information. Further, the secondary monitoring information may be calculated for each battery cell.

Here, in the arithmetic processing of the control unit, the secondary monitoring information is calculated using correlation data, conversion map data, or the like indicating the correlation between the primary monitoring information and the secondary monitoring information. In this case, the correlation data, map data, or the like are considered to be maker-specific know-how information for battery makers and vehicle makers. That is, it can be said that the correlation data, the map data, or the like for acquiring the secondary monitoring information are confidential information for the maker, and the outflow of such information to a third party is desired to be avoided. On the other hand, history information, which is a history of the primary monitoring information and the secondary monitoring information acquired during primary use, can be utilized as information on the usage history of the battery module during reuse of the battery module. For example, during primary use of the battery module, it is conceivable that deterioration or damage of the battery module occurs to some extent, and by using the history information during the primary use at the time of reusing the battery module, it becomes possible to reuse the battery module while considering the damage received during the primary use.

In view of these, it is configured that the monitoring unit has the storage unit in which at least one of the primary monitoring information and the secondary monitoring information is stored, and the control unit is detachable from the assembly including the battery module and the monitoring unit in the battery unit. In this case, when the battery module is reused after the primary use of the battery module, the information to be kept secret included in the control unit is separated from the battery module, and the history information referable at the time of battery reuse is attached to the battery module side. That is, at the time of reusing the battery module, the outflow of maker know-how is suppressed by the detachment of the control unit, and the battery module can be reused while corresponding to the history information acquired during primary use. As a result, reuse of the battery module can be performed appropriately.

The monitoring unit may acquire at least one of voltage information, current information, and temperature information of the battery module as the primary monitoring information. Further, the control unit may calculate at least one of electric capacity information of the battery module, deterioration information, and over-temperature information of the battery module as the secondary monitoring information based on the voltage information, the current information, or the temperature information of the battery module.

### BRIEF DESCRIPTION OF DRAWINGS

The above and other objects, features, and advantages of the present disclosure will become more apparent from the following detailed description with reference to the accompanying drawings. In the drawings:
Fig. 1 is an overall configuration diagram of a power supply system;
Fig. 2 is a perspective view showing a schematic configuration of a battery unit;
Fig. 3 is a configuration diagram showing an electrical configuration of the battery unit;
Fig. 4 is a flowchart showing processing executed by a first monitoring unit, a control unit, and a second monitoring unit;
Fig. 5 is a diagram showing a state in which the first monitoring unit and the control unit are detached from an assembly including a battery module and the second monitoring unit;
Fig. 6 is a diagram showing a state in which a battery control device is connected to the second monitoring unit during battery reuse;
Fig. 7 is an electrical configuration diagram showing an electrical configuration of a battery unit in a second embodiment;
Fig. 8 is a flowchart showing processing executed by a monitoring unit and a control unit in the second embodiment;
Fig. 9 is a flowchart showing processing executed by a control unit in another example; and
Fig. 10 is a diagram showing a configuration of a power supply unit in a battery unit in another example.

### DESCRIPTION OF EMBODIMENTS

Hereinafter, embodiments embodying a battery unit according to the present disclosure will be described with reference to the drawings. The battery unit is mounted on an electric vehicle such as an electric automobile or a hybrid automobile, for example, and an in-vehicle power supply system is constructed including the battery unit. This power supply system has a high-voltage battery in which a voltage between positive and negative terminals is several hundred volts. In addition to electric vehicles, the battery unit is widely applicable to devices using the battery unit as a power source, such as flying objects like drones, ships, construction machinery, and agricultural machinery.

### (First Embodiment)

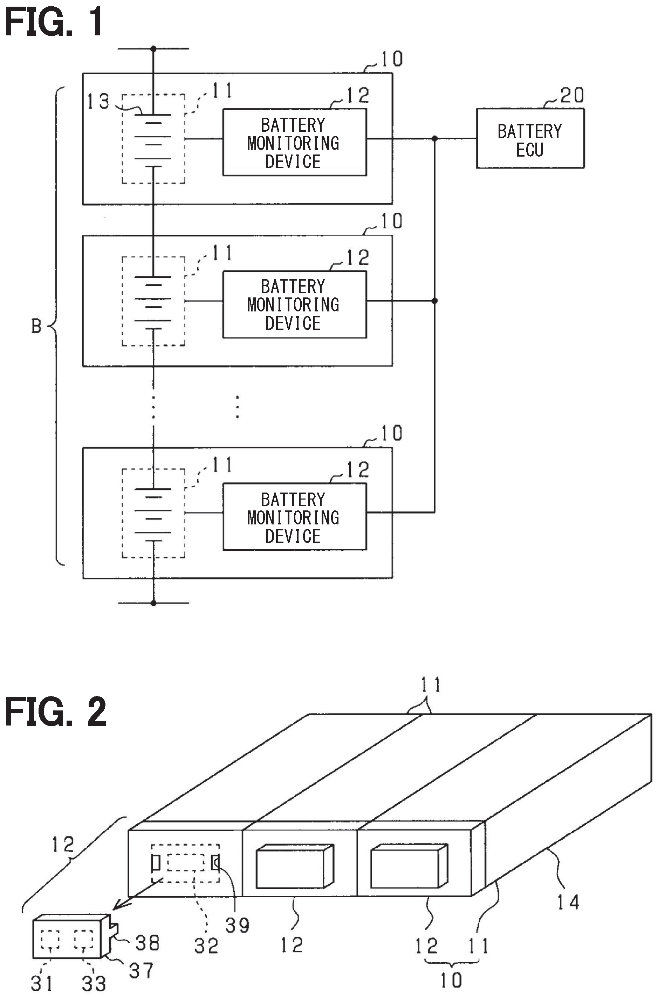

First, an outline of a power supply system in a vehicle will be described with reference to Fig. 1. In Fig. 1, the power supply system has a plurality of battery units 10 and a battery ECU 20 that centrally manages the respective battery units 10. The battery unit 10 has a battery module 11 and a battery monitoring device 12 monitoring the battery module 11. The battery module 11 is configured by connecting a plurality of battery cells 13 in series. Each battery cell 13 is composed of, for example, a lithium-ion secondary battery or a nickel-metal hydride secondary battery. The lithium-ion secondary battery is a secondary battery using lithium as a charge carrier, and may include an all-solid-state battery using a solid electrolyte in addition to a general lithium-ion secondary battery using a liquid electrolyte.

The battery modules 11 of the respective battery units 10 are connected in series to form an assembled battery B. The assembled battery B is a high-voltage battery generating a terminal voltage of several hundred volts. In the vehicle, electric power is supplied from the assembled battery B to a rotating electrical machine which is a travel drive source. Note that the assembled battery B may be one in which the respective battery modules 11 are connected in parallel, or one in which the respective battery modules 11 are connected in series and parallel.

The battery monitoring device 12 of each battery unit 10 is a slave unit with the battery ECU 20 as a master unit, and the battery ECU 20 and the plurality of battery monitoring devices 12 can communicate with each other by wired or wireless communication means, respectively. The battery ECU 20 is composed of a microcomputer including a CPU, a ROM, a RAM, and the like. The battery ECU 20 executes various processes regarding battery control based on a program stored in the ROM. The battery ECU 20 executes, for example, control regarding charging or discharging of the assembled battery B. The battery monitoring device 12 acquires information regarding the battery module 11 in response to a command from the battery ECU 20, and transmits the information to the battery ECU 20. The battery monitoring device 12 may acquire information regarding the battery module 11 at a predetermined cycle. Note that the battery monitoring device 12 is also referred to as a satellite monitoring device.

Fig. 2 is a perspective view showing a schematic configuration of a plurality of battery units 10 mounted on a vehicle. The battery unit 10 has a battery module 11 having, for example, a rectangular parallelepiped shape, and a battery monitoring device 12 provided integrally with the battery module 11. The battery module 11 is configured by accommodating a plurality of battery cells 13 in a rectangular parallelepiped casing 14. The battery monitoring device 12 is provided, for example, on one end side in the longitudinal direction of the battery module 11. Note that the battery monitoring device 12 may be accommodated in the casing 14 or may be disposed outside the casing 14.

A plurality of battery units 10 are mounted on the vehicle, for example, arranged side by side in a direction orthogonal to the longitudinal direction of the battery unit 10. In the battery unit 10, the battery monitoring device 12 can be detached from the battery module 11 assuming reuse of the battery module 11 after finishing primary use. The battery monitoring device 12 includes a portion remaining on the battery module 11 side upon detachment from the battery module 11 and a portion detached from the battery module 11 side, details of which will be described later.

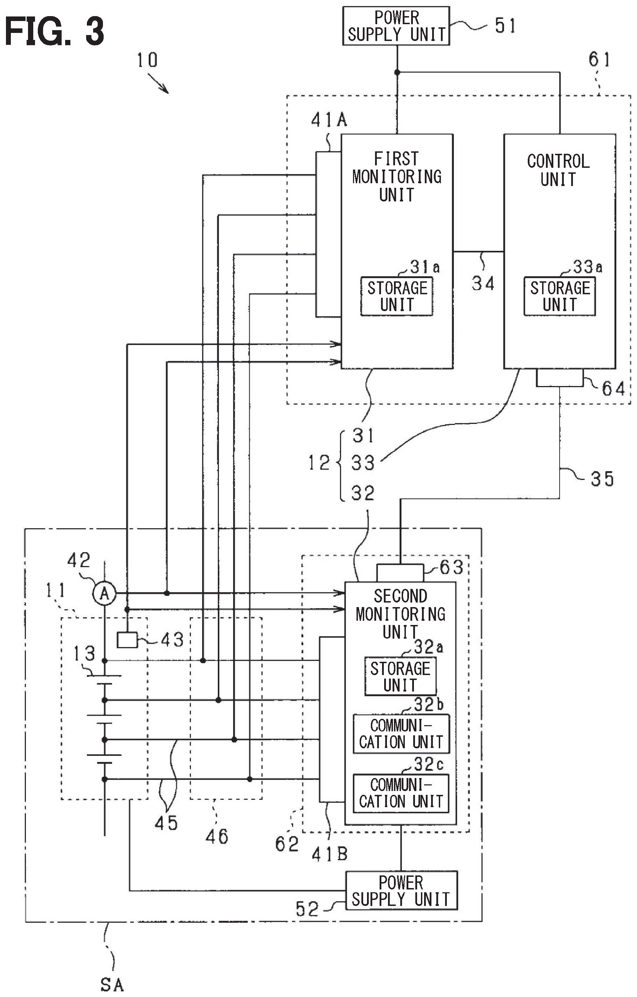

Fig. 3 is a configuration diagram showing an electrical configuration of the battery unit 10. In the battery unit 10, the battery monitoring device 12 has a first monitoring unit 31, a second monitoring unit 32, and a control unit 33. The first monitoring unit 31 and the control unit 33 are connected by a signal line 34, and the second monitoring unit 32 and the control unit 33 are connected by a signal line 35.

The first monitoring unit 31 and the second monitoring unit 32 are both monitoring ICs having a monitoring function of monitoring the state of the battery module 11. That is, in the battery unit 10 of the present embodiment, the monitoring units 31 and 32 are provided redundantly. Each of these monitoring units 31 and 32 is connected in parallel to the control unit 33. Each of the monitoring units 31 and 32 has storage units 31a and 32a for storing information which is a monitoring result of the battery module 11. The storage units 31a and 32a are memories enabling writing and storage of data.

The first monitoring unit 31 acquires detection results of various sensors provided in the battery module 11 as primary monitoring information. The primary monitoring information includes, for example, voltage information, current information, temperature information, and the like of each battery cell 13 constituting the battery module 11. In the battery unit 10, as a detection unit for detecting the primary monitoring information, a voltage sensor 41 detecting a voltage across terminals of each battery cell 13, a current sensor 42 detecting a current flowing through each battery cell 13, and a temperature sensor 43 detecting a temperature of each battery cell 13 are provided. Detection signals of the respective sensors 41 to 43 are inputted to the first monitoring unit 31 and the second monitoring unit 32, respectively.

In Fig. 3, the voltage sensor 41 is provided in each of the first monitoring unit 31 and the second monitoring unit 32, and the voltage sensor 41 provided in the first monitoring unit 31 is referred to as a voltage sensor 41A, and the voltage sensor 41 provided in the second monitoring unit 32 is referred to as a voltage sensor 41B. Specifically, in the battery module 11, electrical paths 45 are connected to both ends of each battery cell 13, respectively. Each electrical path 45 branches into two paths, one of which is connected to the voltage sensor 41A of the first monitoring unit 31, and the other of which is connected to the voltage sensor 41B of the second monitoring unit 32. However, the above configuration is an example and can be changed. For example, the voltage sensor 41 can be provided on the battery module 11 side. Note that the electrical path 45 is preferably provided with a wiring connector 46 capable of detaching a branch portion of a path (wiring) leading to each of the voltage sensors 41A and 41B.

The current sensor 42 is preferably provided in a cell series path of the battery module 11. One temperature sensor 43 may be provided for each battery module 11, or a plurality of temperature sensors 43 may be provided in each battery module 11. The current sensor 42 and the temperature sensor 43 are provided as part of the battery module 11. In addition to the sensors 41 to 43 described above, the battery unit 10 may be provided with a sensor detecting distortion, generation of gas, or pressure change of each battery cell 13.

The first monitoring unit 31 captures detection results of the voltage sensor 41, the current sensor 42, and the temperature sensor 43, and stores them in the storage unit 31a as time-series history information. At this time, the first monitoring unit 31 stores the detection results of the respective sensors 41 to 43, which are primary monitoring information, in the storage unit 31a in time series. Further, the first monitoring unit 31 performs self-diagnosis based on whether or not the detection values of the respective sensors 41 to 43 fall within a predetermined range determined in advance, and if it is determined that they do not fall within the predetermined range, information indicating that fact is stored in the storage unit 31a. Regarding the sensor detection results, a configuration may be adopted in which those falling within the predetermined range and those falling out of the predetermined range are sorted and stored. Further, the first monitoring unit 31 outputs the primary monitoring information to the control unit 33.

The control unit 33 is composed of a microcomputer including a CPU, a ROM, a RAM, and the like. The control unit 33 has a communication function enabling communication with the battery ECU 20. The control unit 33 executes various processes regarding battery monitoring based on programs, correlation data, conversion maps, and the like stored in the ROM. In the backup area of the RAM in the control unit 33, a chassis number, a registration number, or the like is stored as identification information of the vehicle on which the battery unit 10 is mounted. Note that the chassis number, registration number, and the like are information associated with the owner's name of the vehicle and correspond to "owner information". The owner information can also be rephrased as vehicle user information or personal information.

Based on the primary monitoring information inputted from the first monitoring unit 31, the control unit 33 calculates SOC (State Of Charge), SOH (State Of Health), and impedance of each battery cell 13 as secondary monitoring information. Specifically, the control unit 33 calculates the SOC of each battery cell 13 based on the open circuit voltage (OCV) and energization current of each battery cell 13 using predetermined correlation data, conversion maps, and the like. In addition, the control unit 33 calculates the SOH of each battery cell 13 based on a change in full charge capacity of the battery cell 13 from an initial state or an impedance change of the battery cell 13 from an initial state using predetermined correlation data, conversion maps, and the like. Furthermore, the control unit 33 calculates the impedance of each battery cell 13 based on a current change and a voltage change of each battery cell 13 according to a predetermined processing procedure.

Further, the control unit 33 determines that the battery cell 13 is in an overcharged state or an overdischarged state based on the terminal voltage or SOC of each battery cell 13. At this time, the control unit 33 compares the terminal voltage or SOC of each battery cell 13 with a predetermined overcharge determination value or overdischarge determination value, and determines that the battery cell 13 is overcharged or overdischarged from the result of the comparison.

Further, based on the temperature of the battery module 11 and at least one of the SOC and SOH of each battery cell 13, the control unit 33 executes processing for determining a current value enabling charging to the battery module 11 and processing for determining a current value enabling discharging from the battery module 11.

In the control unit 33, arithmetic processing for calculating the SOC, SOH, and impedance of each battery cell 13, and data such as conversion maps are know-how information of a maker manufacturing the power supply system or the vehicle, and are maker-specific confidential information. This confidential information is stored in the ROM area of the control unit 33. In the battery unit 10, during primary use, detection results (voltage, current, temperature) detected by the respective sensors 41 to 43 are acquired as primary monitoring information by the first monitoring unit 31. In addition, secondary monitoring information such as SOC, SOH, and cell impedance is calculated by the control unit 33 through arithmetic processing based on the primary monitoring information inputted from the first monitoring unit 31.

The second monitoring unit 32 has a function similar to that of the first monitoring unit 31, captures detection results of the voltage sensor 41, the current sensor 42, and the temperature sensor 43, and stores them in the storage unit 32a. The second monitoring unit 32 is a monitoring unit provided redundantly to the first monitoring unit 31.

The second monitoring unit 32 has a communication unit 32b enabling communication with the control unit 33. In the second monitoring unit 32, information from the control unit 33, that is, history information of primary monitoring information and history information of secondary monitoring information during primary use is received by the communication unit 32b. Further, the second monitoring unit 32 preferably has a communication unit 32c separate from the communication unit 32b. The communication unit 32c is a communication device enabling communication with a communication partner other than the control unit 33, and may be either one enabling wired communication or one enabling wireless communication. The communication unit 32c preferably has a communication method different from that of the communication unit 32b. For example, while the communication unit 32b is configured to be capable of communication by a communication method used within the battery unit 10 (a communication method enabling communication with the control unit 33) during primary use, the communication unit 32c is preferably configured to be capable of communication by a communication method used in communication with an external device such as a control device different from the control unit 33 after primary use. The second monitoring unit 32 may have three or more communication units, and essentially, it suffices to have a plurality of communication units with different communication methods.

The battery unit 10 of the present embodiment enables reuse (secondary use) of the battery module 11 after primary use is finished, and a configuration for suitably realizing battery reuse will be described in detail below.

In Fig. 3, the battery unit 10 includes a power supply unit 51 for supplying power to the first monitoring unit 31 and the control unit 33, and a power supply unit 52 for supplying power to the second monitoring unit 32. That is, the first monitoring unit 31 and the control unit 33, and the second monitoring unit 32 are configured to be supplied with power from mutually different power supply units 51 and 52. The power supply unit 51 is connected to a low-voltage battery (not shown) (for example, a 12V battery) mounted on the vehicle, and generates a power supply voltage for operating the first monitoring unit 31 and the control unit 33 by power supply from the low-voltage battery. The power supply unit 52 is connected to the battery module 11, and generates a power supply voltage for operating the second monitoring unit 32 by power supply from the battery module 11.

In the battery unit 10, the first monitoring unit 31 and the control unit 33 are mounted on a substrate 61, and the second monitoring unit 32 is mounted on another substrate 62 different from the substrate 61. Further, the signal line 35 is connected to the second monitoring unit 32 and the control unit 33 via connectors 63 and 64, respectively. Note that the first monitoring unit 31 and the control unit 33 may be mounted on mutually different substrates, and the first monitoring unit 31 and the control unit 33 may be connected by the signal line 34 via a connector. In the battery unit 10, the first monitoring unit 31 and the second monitoring unit 32 may be mutually connected by a signal line.

According to the configuration of Fig. 3, the first monitoring unit 31 and the control unit 33, and the second monitoring unit 32 are mounted on mutually different substrates 61 and 62, and the respective monitoring units 31 and 32 are mutually detachable by the connectors 63 and 64. Therefore, by disconnecting the signal line 35 using the connectors 63 and 64, the first monitoring unit 31 and the control unit 33 can be detached from the assembly SA including the battery module 11 and the second monitoring unit 32. Further, as described above, since each battery cell 13 of the battery module 11 and each monitoring unit 31, 32 are connected by the electrical path 45 branched in two directions, and the wiring connector 46 is provided at the branch portion, the first monitoring unit 31 can be detached from the battery module 11 on the assembly SA side by disconnecting the wiring connector 46. Although illustration is omitted, regarding the current sensor 42 and the temperature sensor 43 as well, it is preferable that the first monitoring unit 31 is detachable from each sensor 42, 43 on the assembly SA side by disconnecting a connector provided in a sensor signal line.

Further, the first monitoring unit 31 and the control unit 33, and the second monitoring unit 32 are individually provided with the power supply units 51 and 52, respectively. Therefore, even if the first monitoring unit 31 and the control unit 33 are detached from the assembly SA including the battery module 11 and the second monitoring unit 32, interruption of power supply to the second monitoring unit 32 accompanying the detachment is suppressed. Particularly in the present embodiment, since the power supply unit 52 is configured to generate power using the battery module 11 as a power supply source, power can be supplied to the second monitoring unit 32 without using an external power source outside the battery unit. A configuration in which a secondary battery is provided as the power supply unit 52 in the assembly SA may be adopted.

In order to realize a configuration in which power supply to the second monitoring unit 32 is continuously performed even after the first monitoring unit 31 and the control unit 33 are detached from the assembly SA, a configuration may be adopted in which one power supply unit (for example, the power supply unit 52 in Fig. 3) is provided in the assembly SA, and power is supplied from the power supply unit to each monitoring unit 31, 32 and the control unit 33, that is, to the battery monitoring device 12.

As shown in Fig. 2, the first monitoring unit 31 and the control unit 33 are preferably structured to be detachable from, for example, the outer peripheral surface of the casing 14 of the battery module 11. Specifically, it is preferable that the first monitoring unit 31 and the control unit 33 are configured to be assembled to the casing 14 of the battery module 11 by fastening with fasteners such as screws or mechanical coupling such as snap fit, and the first monitoring unit 31 and the control unit 33 can be detached from the casing 14 of the battery module 11 by releasing the screw fastening or mechanical coupling.

In Fig. 2, the first monitoring unit 31 and the control unit 33 of the battery monitoring device 12 are integrally configured as a separation unit 37, and the separation unit 37 is provided with a coupling portion 38 attachable to and detachable from the casing 14 or the like on the battery module 11 side (assembly SA side). On the battery module 11 side, an accommodation portion accommodating the second monitoring unit 32 is provided with a coupled portion 39 to which the coupling portion 38 is coupled. When the separation unit 37 is detached from the battery module 11 side, connectors and the like are disconnected along with the detachment, so that the second monitoring unit 32 and the control unit 33 are electrically disconnected, and the battery module 11 and the first monitoring unit 31 are electrically disconnected.

Next, processing regarding information management during primary use of the battery module 11 and during subsequent battery reuse will be described.

In the present embodiment, focusing on the fact that confidential information, which is information regarding maker know-how, is stored in the memory (ROM) of the control unit 33, outflow of maker know-how information is intended to be suppressed during battery reuse after finishing primary use.

In addition, primary monitoring information (detection information of voltage, current, temperature) and secondary monitoring information (information of SOC, SOH, cell impedance, etc.) acquired during primary use can be utilized as information for determining a usage mode or the like of the battery module 11 during reuse of the battery module 11. Therefore, the primary monitoring information and the secondary monitoring information acquired during the primary use are stored as time-series history information in the storage unit 32a of the second monitoring unit 32 so that they can be used during the reuse of the battery module 11. For example, it is conceivable that the battery module 11 is damaged to some extent during primary use of the battery unit 10, and by using the history information during the primary use at the time of reusing the battery module 11, it is possible to reuse the battery module while considering the damage received during the primary use.

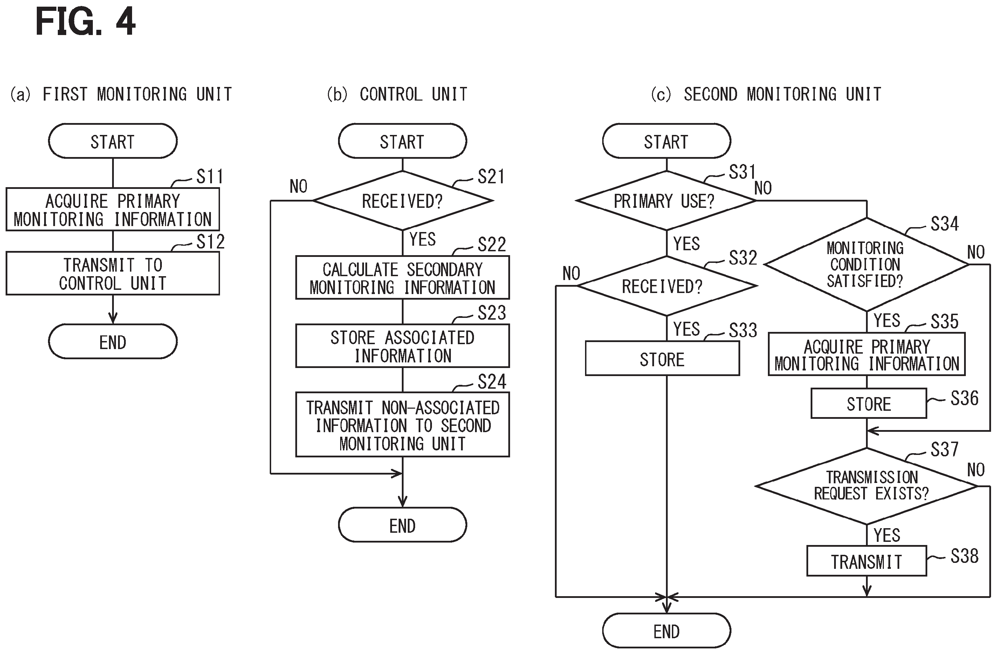

Hereinafter, the procedure of battery monitoring processing by each monitoring unit 31, 32 and the control unit 33 in the battery unit 10 will be described. (a) of Fig. 4 is a flowchart showing battery monitoring processing executed by the first monitoring unit 31, (b) of Fig. 4 is a flowchart showing battery monitoring processing executed by the control unit 33, and (c) of Fig. 4 is a flowchart showing battery monitoring processing executed by the second monitoring unit 32. Each of these processes is repeatedly executed at a predetermined cycle.

As shown in (a) of Fig. 4, the first monitoring unit 31 acquires detection signals of voltage, current, temperature, etc., by the respective sensors 41 to 43 as primary monitoring information in step S11. Note that a configuration may be adopted in which the first monitoring unit 31 acquires detection signals of the respective sensors 41 to 43 every predetermined time, or a configuration may be adopted in which the first monitoring unit 31 acquires detection signals of the respective sensors 41 to 43 in response to a signal output request from the control unit 33. Thereafter, in step S12, the primary monitoring information is transmitted to the control unit 33.

As shown in (b) of Fig. 4, the control unit 33 determines whether or not primary monitoring information has been received from the first monitoring unit 31 in step S21. If step S21 is affirmative, the process proceeds to the subsequent step S22. In step S22, SOC, SOH, impedance, etc., are calculated as secondary monitoring information of each battery cell 13 based on the primary monitoring information (sensor detection signals) transmitted from the first monitoring unit 31. At this time, based on the voltage information of each battery cell 13, the control unit 33 preferably calculates charge/discharge information regarding overcharge or overdischarge of each battery cell 13 as the secondary monitoring information, and calculates deterioration information indicating the degree of deterioration of each battery cell 13 as the secondary monitoring information based on the voltage information and current information of each battery cell 13. Further, a configuration may be adopted in which the control unit 33 performs determination that rapid charging of the battery module 11 has been performed and calculation of the number of times of rapid charging based on the voltage information of each battery cell 13, and information regarding the rapid charging may be the secondary monitoring information. In addition, in a configuration having a strain sensor as a detection unit, a configuration may be adopted in which the control unit 33 determines the presence or absence of an impact occurring in the battery unit 10 based on a detection result of strain, and information regarding the presence or absence of the impact may be the secondary monitoring information.

Thereafter, in step S23, the primary monitoring information and the secondary monitoring information are associated with owner information, and the associated information is stored in the storage unit 33a. The associated information can also be said to be association information in which owner information is associated with the primary monitoring information and the secondary monitoring information. The associated information is information in which owner information such as a chassis number or a registration number of the vehicle is associated with voltage information, current information, and temperature information which are primary monitoring information. Further, the associated information is information in which owner information such as a chassis number or a registration number of the vehicle is associated with SOC, SOH, and cell impedance which are secondary monitoring information. In addition, when charge/discharge information or deterioration information of each battery cell 13 is calculated as the secondary monitoring information, the associated information is information in which owner information such as a chassis number or a registration number of the vehicle is associated with the charge/discharge information or deterioration information.

In step S23, the control unit 33 may cause the storage unit 31a of the first monitoring unit 31 to store the associated information in which the primary monitoring information and the secondary monitoring information are associated with the owner information, instead of storing it in the storage unit 33a of the control unit 33. Further, the control unit 33 may transmit the associated information to the battery ECU 20 as an external device. In the battery ECU 20, the associated information is preferably stored in time series.

In step S24, non-associated information, which is history information in which the primary monitoring information and the secondary monitoring information are not associated with the owner information, is transmitted to the second monitoring unit 32. The non-associated information can also be said to be non-association information in which owner information is not associated with the primary monitoring information and the secondary monitoring information. Along with the transmission of the non-associated information to the second monitoring unit 32, the non-associated information is stored in the storage unit 32a in the second monitoring unit 32. At this time, the control unit 33 causes the storage unit 32a of the second monitoring unit 32 to store voltage information, current information, and temperature information which are primary monitoring information, and SOC, SOH, and cell impedance which are secondary monitoring information without associating them with the owner information. In addition, when charge/discharge information or deterioration information of each battery cell 13 is calculated as the secondary monitoring information, the control unit 33 causes the storage unit 32a of the second monitoring unit 32 to store the charge/discharge information or deterioration information without associating them with the owner information. Note that the control unit 33 may transmit non-associated information for either one of the primary monitoring information and the secondary monitoring information to the second monitoring unit 32.

The associated information in which history information, which is a history of primary monitoring information or secondary monitoring information, is associated with vehicle owner information is preferably used when, for example, inspecting or repairing the vehicle. In this case, appropriate work can be performed while corresponding the primary monitoring information or secondary monitoring information to the owner (vehicle user).

As shown in (c) of Fig. 4, the second monitoring unit 32 determines in step S31 whether or not it is currently during primary use of the battery unit 10. This determination is preferably performed by, for example, determining whether or not the first monitoring unit 31 and the control unit 33 are detached from the assembly SA including the battery module 11 and the second monitoring unit 32. In this case, if the first monitoring unit 31 and the control unit 33 are not detached from the assembly SA including the battery module 11 and the second monitoring unit 32, it is determined to be during primary use, and if they are detached, it is determined not to be during primary use. For example, it is preferable to determine that it is not during primary use based on the fact that the control unit 33 is not connected to the second monitoring unit 32, or that a transmission signal from the control unit 33 has not been inputted to the second monitoring unit 32 for a predetermined time. Alternatively, a configuration may be adopted in which a command signal indicating that it is during primary use is inputted to the second monitoring unit 32. If it is during primary use, the process proceeds to step S32, and if it is not during primary use, the process proceeds to step S34.

In step S32, it is determined whether or not information transmitted from the control unit 33 has been received. If information has been received from the control unit 33, the process proceeds to step S33, and the information received from the control unit 33, that is, non-associated information in which the primary monitoring information and the secondary monitoring information are not associated with the owner information is stored in the storage unit 32a.

In step S34, it is determined whether or not a monitoring condition for monitoring the state of the battery module 11 is currently satisfied. This monitoring condition includes that a predetermined time has elapsed since the previous monitoring of the battery module 11 by the second monitoring unit 32 after primary use of the battery module 11, that a monitoring request for the battery module 11 from an external device or the like has been received, and the like. Then, on condition that step S34 is affirmative, the process proceeds to the subsequent step S35.

In step S35, detection signals of voltage, current, temperature, etc., by the respective sensors 41 to 43 are acquired as primary monitoring information. In step S36, the primary monitoring information is stored in the storage unit 32a. Note that in a state where the battery module 11 is stored before secondary use after primary use of the battery module 11, only voltage information may be acquired as the primary monitoring information.

In step S37, it is determined whether or not a transmission request for primary monitoring information has been received from an external device capable of communicating with the second monitoring unit 32. The external device is an information collection device such as a server capable of communicating with the second monitoring unit 32 by wired communication or wireless communication. In a state where the battery module 11 is being reused (secondary use), the external device is a host control device capable of communicating with the second monitoring unit 32. The external device is preferably provided with a storage unit storing primary monitoring information during battery reuse. If step S37 is affirmative, the process proceeds to step S38.

In step S38, the primary monitoring information acquired by the second monitoring unit 32 is transmitted to the external device in response to the transmission request.

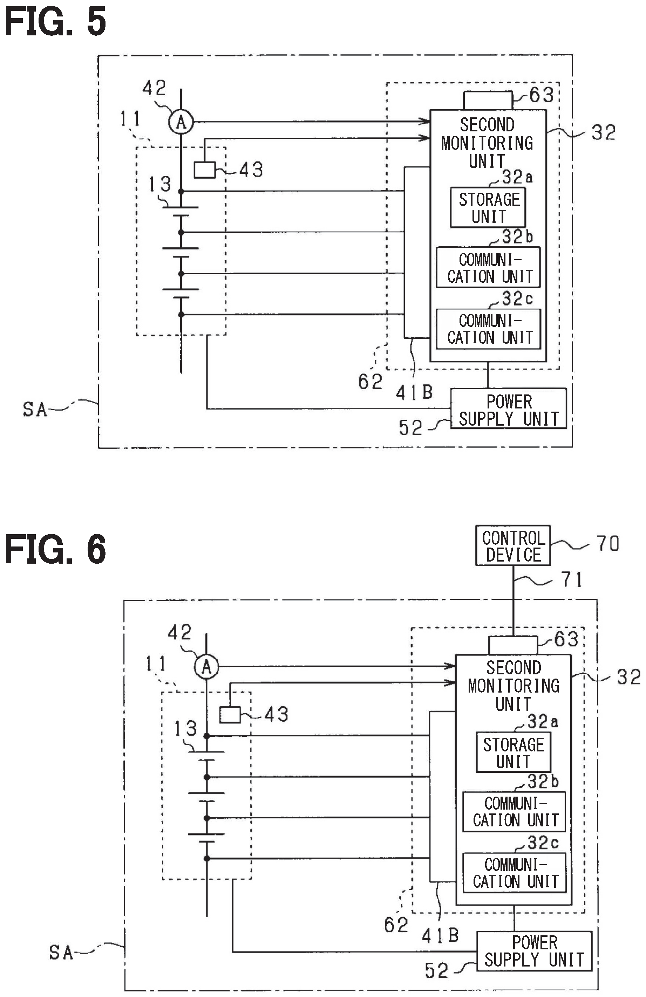

In the battery unit 10, after finishing primary use, the first monitoring unit 31 and the control unit 33 are detached from the assembly SA including the battery module 11 and the second monitoring unit 32. This state is the state shown in Fig. 5. At this time, since the first monitoring unit 31 and the control unit 33 are collected, leakage of information such as maker know-how stored in the ROM area of the control unit 33 is suppressed.

In the state of Fig. 5, the second monitoring unit 32 determines that it is not during primary use of the battery unit 10, and monitoring processing of the battery module 11 is executed. At this time, the second monitoring unit 32 acquires detection results of the respective sensors 41 to 43 as primary monitoring information in place of the first monitoring unit 31. The second monitoring unit 32 is configured to be operable even without a command from the control unit 33 (a configuration capable of realizing functions in a stand-alone manner). Therefore, monitoring of the battery module 11 by the second monitoring unit 32 is possible even before reuse of the battery module 11 starts after primary use.

By monitoring the state of the battery module 11 by the second monitoring unit 32 in the period from after primary use of the battery unit 10 until secondary use starts, processing such as confirming the state of charge of the battery module 11 by charge/discharge tests or the like before the start of secondary use becomes unnecessary. Therefore, the cost required for preparation for secondary use of the battery module 11 can be reduced.

The assembly SA including the battery module 11 and the second monitoring unit 32 has the power supply unit 52 supplying power to the second monitoring unit 32. Therefore, even after the battery unit 10 is unloaded from the vehicle and the first monitoring unit 31 and the control unit 33 are detached from the assembly SA, interruption of power supply to the second monitoring unit 32 is suppressed, and appropriate operation of the second monitoring unit 32 is enabled. Particularly in this case, since the power supply unit 52 generates a power supply voltage using the battery module 11 as a power supply source, power supply to the second monitoring unit 32 is possible without using an external power source (for example, an in-vehicle low-voltage battery) outside the unit. In addition, it is possible to carry out battery monitoring even for the battery module 11 in a storage state or a transportation state after primary use.

Under the storage state of the battery module 11 after primary use, it is preferable that transmission of primary monitoring information from the second monitoring unit 32 to an external device such as a server is possible. Thereby, even in a state where the battery unit 10 is removed from the vehicle after primary use, the state of the battery module 11 is properly managed. Note that management information (primary monitoring information) of the battery module 11 stored in the external device is preferably readable. In this case, access rights are preferably defined by a predetermined authentication means.

Fig. 6 is a diagram showing a state in which a battery control device 70 is connected to the second monitoring unit 32 during reuse of the battery module. In Fig. 6, the battery control device 70 is connected to the connector 63 of the second monitoring unit 32 via a signal line 71. The battery control device 70 is a host control device capable of inputting signals from the second monitoring unit 32 in a secondary use system.

In the assembly SA after finishing primary use, history information regarding primary monitoring information and secondary monitoring information during primary use is stored in the storage unit 32a of the second monitoring unit 32. Therefore, after primary use of the battery module 11, at the time of designing the secondary use system, the mode of battery use is determined based on the history information during primary use stored in the storage unit 32a of the second monitoring unit 32. In this case, regarding the battery module 11 which has suffered deterioration or damage to some extent in primary use, safe use of the battery module 11 in secondary use can be realized while considering how it was used in primary use. At this time, it is preferable that the secondary use system is designed after grasping information such as the number of times of overcharge/overdischarge, the number of times of rapid charging, the presence or absence of impact, etc., as secondary monitoring information of the battery module 11 during primary use.

During secondary use, the history information stored in the storage unit 32a of the second monitoring unit 32 is non-associated information not associated with owner information. Therefore, during secondary use, unintended leakage of owner information during primary use is suppressed.

According to the present embodiment described in detail above, the following excellent effects can be obtained.

The battery unit 10 is configured such that the first monitoring unit 31 and the control unit 33 are detachable from the assembly SA including the battery module 11 and the second monitoring unit 32. In this case, when the battery module 11 is reused after primary use of the battery module 11, the information to be kept secret included in the control unit 33 is separated from the battery module 11, and the history information referable at the time of battery reuse is attached to the battery module 11 side. That is, at the time of reusing the battery module 11, the outflow of maker know-how is suppressed by the detachment of the control unit 33, and the battery module 11 can be reused while corresponding to the history information acquired during primary use. As a result, reuse of the battery module 11 can be performed appropriately.

In the battery unit 10, the configuration having the first monitoring unit 31 and the second monitoring unit 32 enables redundant provision of the battery monitoring function. Further, during primary use of the battery module 11, the first monitoring unit 31 acquires detection results of the detection unit (each sensor 41 to 43) as primary monitoring information, and the control unit 33 calculates secondary monitoring information based on the primary monitoring information from the first monitoring unit 31, while history information of the primary monitoring information and the secondary monitoring information is stored (saved) in the storage unit 32a of the second monitoring unit 32. Thereby, at the time of reusing the battery module 11, even if the first monitoring unit 31 and the control unit 33 are detached from the assembly SA including the battery module 11 and the second monitoring unit 32, a monitoring function of the battery module 11 can be imparted to the assembly SA side including the battery module 11 while retaining the history information during primary use.

During primary use of the battery module 11, history information which is a history of primary monitoring information or secondary monitoring information is associated with owner information of the vehicle, and stored in the storage unit 33a of the control unit 33 or transmitted to the battery ECU 20. Thereby, for example, when inspecting or repairing the vehicle, appropriate work can be performed while corresponding the primary monitoring information or secondary monitoring information to the owner (vehicle user).

Similarly, during primary use of the battery module 11, history information of primary monitoring information or secondary monitoring information is stored in the storage unit 32a of the second monitoring unit 32 without associating it with owner information. The storage unit 32a of the second monitoring unit 32 is a storage unit remaining on the assembly SA side after the first monitoring unit 31 and the control unit 33 are detached from the assembly SA. Thereby, during reuse of the battery module 11 after finishing primary use, appropriate battery reuse is possible considering how it was used during primary use while suppressing unintended leakage of owner information during primary use.

In a state where primary use of the battery module 11 is finished and the first monitoring unit 31 and the control unit 33 are detached from the assembly SA including the battery module 11 and the second monitoring unit 32, the second monitoring unit 32 is configured to acquire detection results of the detection unit as primary monitoring information in place of the first monitoring unit 31. Thereby, even after detachment of the first monitoring unit 31 and the control unit 33, monitoring of the battery module 11 can be continuously carried out by the second monitoring unit 32.

The assembly SA including the battery module 11 and the second monitoring unit 32 is configured to have the power supply unit 52 supplying power to the second monitoring unit 32. Thereby, when the first monitoring unit 31 and the control unit 33 are detached from the assembly SA, interruption of power supply to the second monitoring unit 32 accompanying the detachment can be suppressed. Therefore, after finishing primary use of the battery module 11, the second monitoring unit 32 can be operated appropriately even in a state separated from the first monitoring unit 31, the control unit 33, and the like.

Since the power supply unit 52 provided in the assembly SA is configured to generate a power supply voltage using the battery module 11 as a power supply source, the battery monitoring function can be operated independently without using an external power source outside the unit. According to this configuration, after removing the battery module 11 from the vehicle or the like for battery reuse, it is possible to perform battery monitoring even for the battery module 11 in a storage state or a transportation state.

The first monitoring unit 31 and the control unit 33, and the second monitoring unit 32 are mounted on mutually different substrates 61 and 62 and connected to each other by the signal line 35. Further, the first monitoring unit 31 and the control unit 33 can be detached from the assembly SA including the battery module 11 and the second monitoring unit 32 by disconnection of the connectors 63 and 64 provided in the signal line 35. Thereby, the battery unit 10 enabling the first monitoring unit 31 and the control unit 33 to be detachable from the assembly SA can be suitably realized.

### (Second Embodiment)

A second embodiment will be described focusing on differences from the first embodiment.

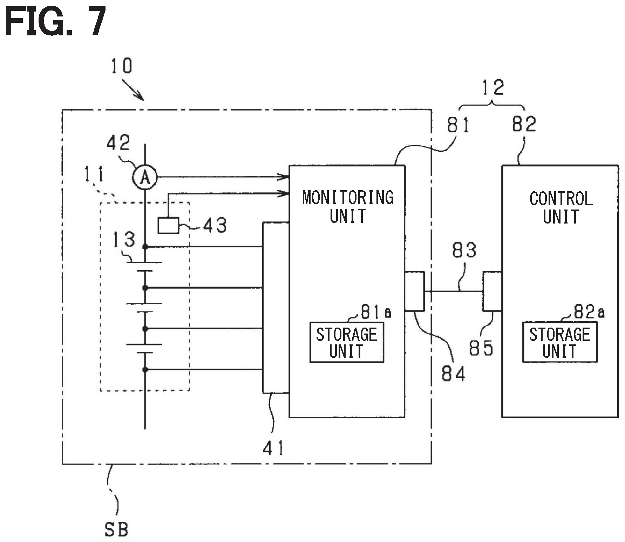

Fig. 7 is a configuration diagram showing a specific configuration of the battery unit 10 in the present embodiment. In the present embodiment, the battery monitoring device 12 is configured to have a monitoring unit 81 and a control unit 82. The monitoring unit 81 has a monitoring function of the battery module 11 similarly to the respective monitoring units 31 and 32 described in the first embodiment. Further, the monitoring unit 81 may have a plurality of communication units with different communication methods similarly to the second monitoring unit 32 of the first embodiment. The control unit 82 has a function of executing various processes regarding battery monitoring similarly to the control unit 33 described in the first embodiment.

The monitoring unit 81 and the control unit 82 are connected by a signal line 83. The monitoring unit 81 and the control unit 82 have storage units 81a and 82a enabling writing and storage of data, respectively. The monitoring unit 81 acquires detection results by the respective sensors 41 to 43 as primary monitoring information, and the control unit 82 calculates secondary monitoring information by arithmetic processing based on the primary monitoring information. In the storage unit 81a of the monitoring unit 81, history information which is a history of at least one of the primary monitoring information and the secondary monitoring information is stored.

The battery unit 10 of the present embodiment enables reuse (secondary use) of the battery module 11 after primary use is finished, similarly to the first embodiment. In the battery unit 10 of Fig. 7, the control unit 82 is detachable from an assembly SB including the battery module 11 and the monitoring unit 81.

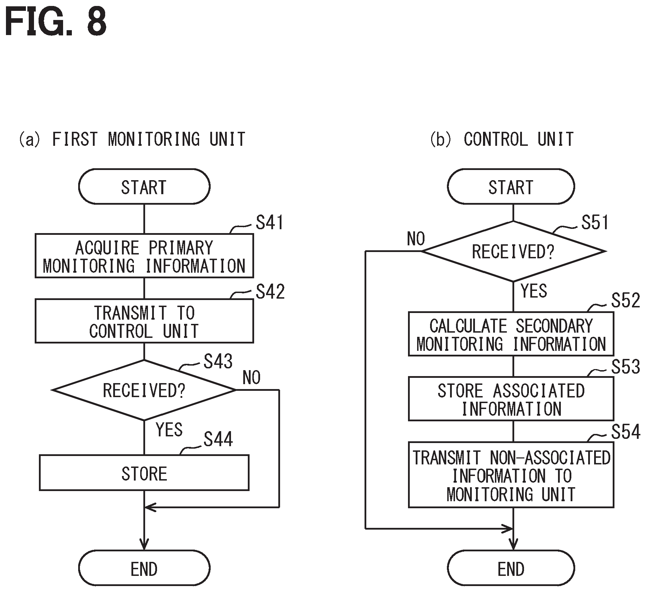

Hereinafter, the procedure of battery monitoring processing by the monitoring unit 81 and the control unit 82 will be described. (a) of Fig. 8 is a flowchart showing battery monitoring processing executed by the monitoring unit 81, and (b) of Fig. 8 is a flowchart showing battery monitoring processing executed by the control unit 82. Each of these processes is repeatedly executed at a predetermined cycle.

As shown in (a) of Fig. 8, the monitoring unit 81 acquires detection signals of voltage, current, temperature, etc., by the respective sensors 41 to 43 as primary monitoring information in step S41. Thereafter, in step S42, the primary monitoring information is transmitted to the control unit 82. Note that the processes of steps S41 and S42 are processes similar to steps S11 and S12 in (a) of Fig. 4.

In step S43, it is determined whether or not information transmitted from the control unit 82 has been received. If information has been received from the control unit 82, the process proceeds to step S44, and the information received from the control unit 82 is stored in the storage unit 81a. Note that the information received in step S44 is "non-associated information" transmitted by the control unit 82 in step S54 described later.

As shown in (b) of Fig. 8, the control unit 82 determines whether or not primary monitoring information has been received from the monitoring unit 81 in step S51. If step S51 is affirmative, the process proceeds to the subsequent step S52. In step S52, SOC, SOH, impedance, etc., are calculated as secondary monitoring information of each battery cell 13 based on the primary monitoring information (sensor detection signals) transmitted from the monitoring unit 81.

Thereafter, in step S53, associated information, which is information in which the primary monitoring information and the secondary monitoring information are associated with owner information, is stored in the storage unit 82a. In step S54, non-associated information, which is information in which the primary monitoring information and the secondary monitoring information are not associated with owner information, is transmitted to the monitoring unit 81. Thereby, the non-associated information is stored in the storage unit 81a in the monitoring unit 81. Note that the processes of steps S52 to S54 are preferably processes conforming to steps S22 to S24 of (a) of Fig. 4.

In the battery unit 10, after finishing primary use, the control unit 82 is detached from the assembly SB including the battery module 11 and the monitoring unit 81. In this case, since the control unit 82 is collected after the primary use, leakage of maker know-how information stored in the ROM area of the control unit 82 is suppressed. Further, monitoring of the state of each battery cell 13 by the monitoring unit 81 is possible even after the primary use.

Since history information regarding primary monitoring information and secondary monitoring information during primary use is stored in the storage unit 81a of the monitoring unit 81 included in the assembly SB, design of the secondary use system is possible while reflecting the history information. However, since the history information stored in the storage unit 81a of the monitoring unit 81 is non-associated information not associated with owner information, unintended leakage of owner information during primary use is suppressed during secondary use of the battery module 11.

During primary use of the battery module 11, history information which is a history of primary monitoring information or secondary monitoring information is associated with owner information of the vehicle, and stored in the storage unit 82a of the control unit 82 or transmitted to the battery ECU 20. Thereby, for example, when inspecting or repairing the vehicle, appropriate work can be performed while corresponding the primary monitoring information or secondary monitoring information to the owner (vehicle user).

Similarly, during primary use of the battery module 11, history information is stored in the storage unit 81a of the monitoring unit 81 without associating it with owner information. The storage unit 81a of the monitoring unit 81 is a storage unit remaining on the assembly SB side after the control unit 82 is detached from the assembly SB. Thereby, during reuse of the battery module 11 after finishing primary use, appropriate battery use is possible considering how it was used during primary use while suppressing unintended leakage of owner information during primary use.

### (Other Embodiments)

The above embodiments may be modified as follows, for example.

In the first embodiment, as shown in (b) of Fig. 4, during primary use of the battery module 11, the control unit 33 stores associated information in which history information (primary monitoring information, secondary monitoring information) is associated with owner information in either of the storage units 31a and 33a or transmits it to the battery ECU 20 capable of communicating with the control unit 33, while storing the history information in the storage unit 32a of the second monitoring unit 32 without associating it with owner information, but this configuration may be changed. For example, a configuration may be adopted in which the first monitoring unit 31 stores associated information in which history information is associated with owner information in the storage unit 31a of the first monitoring unit 31 or transmits it to the battery ECU 20, while storing the history information in the storage unit 32a of the second monitoring unit 32 without associating it with owner information.

Alternatively, during primary use of the battery module 11, the first monitoring unit 31 may perform storage or the like of associated information of primary monitoring information in the storage unit 31a, and cause non-associated information of primary monitoring information to be stored in the storage unit 32a of the second monitoring unit 32. Further, during primary use of the battery module 11, the control unit 33 may perform storage or the like of associated information of secondary monitoring information in the storage unit 33a, and cause non-associated information of secondary monitoring information to be stored in the storage unit 32a of the second monitoring unit 32.

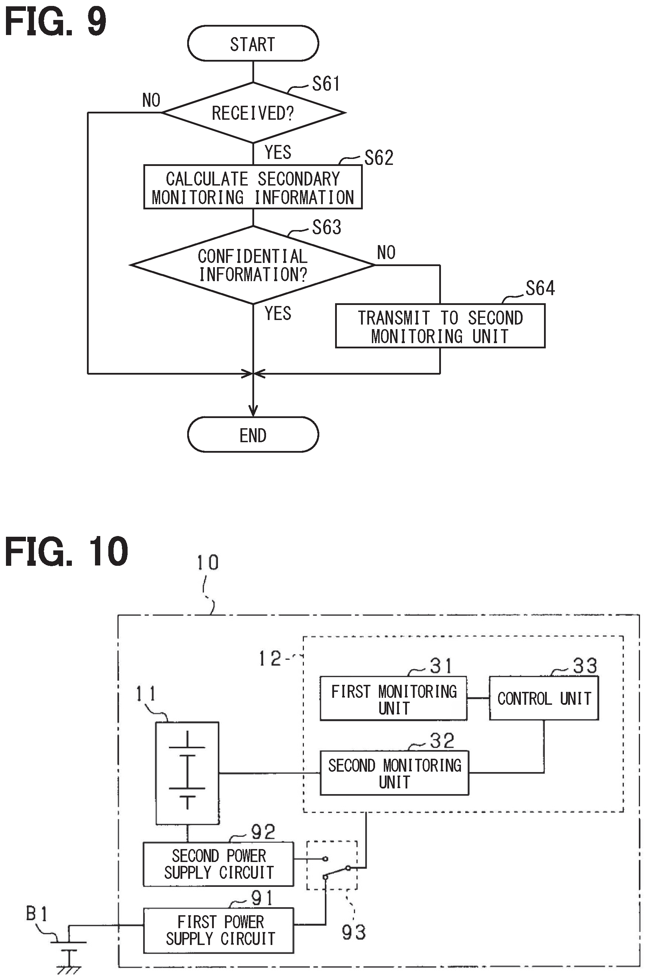

As the battery monitoring process executed by the control unit 33, the process of Fig. 9 may be executed instead of the process in (b) of Fig. 4 described above.

In Fig. 9, in step S61, it is determined whether or not primary monitoring information has been received from the first monitoring unit 31, and if step S61 is affirmative, the process proceeds to the subsequent step S62. In step S62, SOC, SOH, impedance, etc., are calculated as secondary monitoring information of each battery cell 13 based on the primary monitoring information (sensor detection signals) transmitted from the first monitoring unit 31. At this time, based on the voltage information of each battery cell 13, the control unit 33 preferably calculates charge/discharge information regarding overcharge or overdischarge of each battery cell 13 as the secondary monitoring information, and calculates deterioration information indicating the degree of deterioration of each battery cell 13 as the secondary monitoring information based on the voltage information and current information of each battery cell 13. Further, a configuration may be adopted in which the control unit 33 performs determination that rapid charging of the battery module 11 has been performed and calculation of the number of times of rapid charging based on the voltage information of each battery cell 13, and information regarding the rapid charging may be the secondary monitoring information. In addition, in a configuration having a strain sensor as a detection unit, a configuration may be adopted in which the control unit 33 determines the presence or absence of an impact occurring in the battery unit 10 based on a detection result of strain, and information regarding the presence or absence of the impact may be the secondary monitoring information.

Thereafter, in step S63, it is determined whether or not the primary monitoring information and the secondary monitoring information fall under confidential information to be kept secret after finishing primary use. Here, when the battery module 11 is reused after primary use, it is desirable that history information during primary use is taken into account, but excessively detailed information is considered unnecessary. That is, during primary use, repair or replacement work in the vehicle is performed using the history of primary monitoring information or secondary monitoring information, but during reuse, the vehicle itself is replaced, so detailed information becomes unnecessary. Also, the history information may include information that the vehicle owner or the like during primary use does not want to leak to a third party.

For example, among charge/discharge information regarding overcharge or overdischarge of each battery cell 13, information such as date and time or frequency of overcharge/overdischarge and degree of overcharge/overdischarge is set as confidential information, and the number of times of overcharge/overdischarge is set as non-confidential information not to be kept secret. Also, among information of rapid charging of the battery module 11, information such as date and time or frequency of rapid charging is set as confidential information, and the number of times of rapid charging is set as non-confidential information. Regarding primary monitoring information as well, for example, it is conceivable to set information such as cell voltage change or cell temperature change during primary use as confidential information. In step S63, it is preferable to determine whether or not each piece of individual information included in the history information of primary monitoring information or secondary monitoring information falls under confidential information.

If step S63 is affirmative, this process is terminated as it is. In this case, the history information of primary monitoring information and secondary monitoring information is regarded as falling under confidential information, and transmission to the second monitoring unit 32 is not performed. Note that the primary monitoring information and secondary monitoring information regarded as confidential information may be stored in the storage unit 33a of the control unit 33. Further, the primary monitoring information and secondary monitoring information regarded as confidential information may be stored in the storage unit 31a of the first monitoring unit 31 or may be transmitted to the battery ECU 20. If step S63 is negative, the process proceeds to the subsequent step S64. In step S64, information not falling under confidential information among the primary monitoring information and secondary monitoring information is transmitted to the second monitoring unit 32. Thereby, history information that is not confidential information is stored in the storage unit 32a in the second monitoring unit 32.

In steps S63 and S64, the history information may be classified into confidential information and other non-confidential information, and information belonging to confidential information may not be transmitted to the second monitoring unit 32, while information belonging to non-confidential information may be transmitted to the second monitoring unit 32.

During primary use of the battery module 11, it is determined whether or not history information which is a history of primary monitoring information or secondary monitoring information is information to be kept secret during reuse (secondary use) after primary use, and based on the determination result, it is determined whether or not to store the history information in the storage unit 32a of the second monitoring unit 32. Thereby, when the battery module 11 is reused after primary use, appropriate information management can be performed.

Note that a configuration may be adopted in which the process of determining whether or not primary monitoring information or secondary monitoring information is confidential information as described above, or the process of storing history information according to the determination result is executed by the first monitoring unit 31. Further, it is also possible for the first monitoring unit 31 to determine whether primary monitoring information is confidential information and store the primary monitoring information in the storage unit 32a according to the determination result, and for the control unit 33 to determine whether secondary monitoring information is confidential information and store the secondary monitoring information in the storage unit 32a according to the determination result.

The configuration shown in Fig. 10 may be adopted as a power supply unit of the battery monitoring device 12 (each monitoring unit 31, 32 and control unit 33) in the battery unit 10. Fig. 10 shows a configuration of a power supply unit in the battery unit 10 described in Fig. 3.

In Fig. 10, a first power supply circuit 91 and a second power supply circuit 92 are provided as power supply units. The first power supply circuit 91 is a power supply circuit generating a power supply voltage of the battery monitoring device 12 by power supply from outside the unit, and the second power supply circuit 92 is a power supply circuit generating a power supply voltage of the battery monitoring device 12 by power supply from the battery module 11. The power supply supplying power to the first power supply circuit 91 from outside the unit is preferably, for example, an in-vehicle low-voltage battery B1. During primary use of the battery module 11, each monitoring unit 31, 32 and the control unit 33 are operated using the first power supply circuit 91 as a power source, whereas in a state where the first monitoring unit 31 and the control unit 33 are detached from the assembly SA including the battery module 11 and the second monitoring unit 32, the monitoring unit and the control unit are operated using the second power supply circuit 92 as a power source.

Switching between the respective power supply circuits 91 and 92 is preferably performed by a switching device 93 provided between the battery monitoring device 12 and each power supply circuit 91, 92. Switching of the switching device 93 is preferably performed electrically by, for example, the second monitoring unit 32. In this case, the second monitoring unit 32 determines whether or not it is during primary use based on the connection state with the control unit 33 or the like, and if it is during primary use, sets the switching device 93 to a state where the battery monitoring device 12 and the first power supply circuit 91 are connected, and if it is not during primary use, sets the switching device 93 to a state where the battery monitoring device 12 and the second power supply circuit 92 are connected.

It is also possible to adopt a configuration in which a state where power supply power is supplied from the first power supply circuit 91 to the battery monitoring device 12 and a state where power supply power is supplied from the second power supply circuit 92 to the battery monitoring device 12 are mechanically switched. For example, a mechanical switch (switching mechanism) that operates in response to detachment of the first monitoring unit 31 and the control unit 33 from the assembly SA including the battery module 11 and the second monitoring unit 32 and switches the electrical connection state between each power supply circuit 91, 92 and the battery monitoring device 12 may be provided in the battery unit 10, and switching of connection of each power supply circuit 91, 92 may be performed by the mechanical switch.

According to the above configuration, during primary use of the battery module 11, each monitoring unit 31, 32 and the control unit 33 are operated using the first power supply circuit 91 as a power source, whereas in a state where the first monitoring unit 31 and the control unit 33 are detached from the assembly SA including the battery module 11 and the second monitoring unit 32 after primary use, the second monitoring unit 32 can be operated using the second power supply circuit 92 as an alternative power source. In this case, it is possible to appropriately perform battery monitoring even for the battery module 11 in a storage state or a transportation state.

The battery unit 10 described in Fig. 7 may be configured to include the first power supply circuit 91 and the second power supply circuit 92. In this case, switching of the power supply circuits 91 and 92 used as a power source of the battery monitoring device 12 is preferably performed between during primary use of the battery unit 10 and when the control unit 82 is detached from the assembly SB including the battery module 11 and the monitoring unit 81 after primary use.

In each of the above embodiments, both the primary monitoring information and the secondary monitoring information of the battery cell 13 are stored (saved) in the storage unit so as to be usable even after primary use of the battery module 11, but this may be changed. For example, a configuration may be adopted in which only either one of the primary monitoring information and the secondary monitoring information of the battery cell 13 is stored (saved) in the storage unit so as to be usable even after primary use of the battery module 11.

In the battery unit 10 shown in Fig. 3, the second monitoring unit 32 may have a function of calculating secondary monitoring information such as SOC and SOH based on primary monitoring information such as voltage, current, and temperature in each battery cell 13. However, in this case, the second monitoring unit 32 is a component reused together with the battery module 11 after primary use, and outflow of maker know-how information through the second monitoring unit 32 is not desirable. Therefore, calculation of secondary monitoring information by the second monitoring unit 32 is preferably performed more simply than calculation of secondary monitoring information by the first monitoring unit 31. For example, while the first monitoring unit 31 calculates secondary monitoring information using a detailed map with a relatively large data amount, the second monitoring unit 32 calculates secondary monitoring information using a simplified map with a relatively small data amount. That is, according to the above configuration, in the second monitoring unit 32, by reducing the data amount used for arithmetic processing of secondary monitoring information compared to the first monitoring unit 31, it is possible to realize the battery unit 10 enabling acquisition of secondary monitoring information after primary use while minimizing outflow of know-how information.

The battery unit 10 in each of the above embodiments can be applied to an apparatus including a stationary power supply system, in addition to an apparatus which is a mobile body such as a vehicle or an aircraft.

Technical ideas extracted from the above-described embodiments are described below.

### [Configuration 1]

A battery unit (10) includes:
a battery module (11);
a monitoring unit (31, 32, 81) configured to acquire, as primary monitoring information, a detection result obtained by a detection unit (41 to 43) configured to detect a state of the battery module; and
a control unit (33, 82) configured to receive the primary monitoring information from the monitoring unit and configured to calculate secondary monitoring information by arithmetic processing based on the primary monitoring information, wherein
the monitoring unit includes a storage unit (32a, 81a) in which history information indicative of a history of at least one of the primary monitoring information and the secondary monitoring information is stored, and
the control unit is configured to be detachable from an assembly (SA, SB) including the battery module and the monitoring unit.

### [Configuration 2]

In the battery unit as in configuration 1, the monitoring unit includes a first monitoring unit (31) and a second monitoring unit (32),
at least the second monitoring unit includes the storage unit (32a),
during primary use of the battery module, the first monitoring unit among the first and second monitoring units is configured to acquire the detection result of the detection unit as the primary monitoring information, the control unit is configured to calculate the secondary monitoring information based on the primary monitoring information from the first monitoring unit, and the second monitoring unit is configured to store the history information in the storage unit included in the second monitoring unit, and
the first monitoring unit and the control unit are detachable from an assembly (SA) including the battery module and the second monitoring unit.

### [Configuration 3]

The battery unit as in configuration 2 for use in a device that uses the battery unit (10) as a power source, wherein
at least one of the control unit and the first monitoring unit is configured to, during the primary use of the battery module:
associate the history information with owner information corresponding to an owner of the device;
store the associated history information in a storage unit provided in either the control unit or the first monitoring unit or transmit the associated history information to an external device (20) capable of communicating with the control unit; and
cause the storage unit included in the second monitoring unit to store the history information without associating the history information with the owner information.

### [Configuration 4]

In the battery unit as in configuration 3,
the first monitoring unit is configured to acquire voltage information of the battery module as the primary monitoring information,
the control unit is configured to calculate charge/discharge information regarding overcharge, overdischarge or rapid charging of the battery module, as the secondary monitoring information, based on the voltage information, and
at least one of the control unit and the first monitoring unit is configured to, during the primary use of the battery module:
   associate the history information indicative of a history of the charge/discharge information with the owner information;
   store the associated history information in a storage unit provided in either the control unit or the first monitoring unit or transmit the associated history information to an external device (20) capable of communicating with the control unit; and
   cause the storage unit included in the second monitoring unit to store the history information indicative of the history of the charge/discharge information without associating the history information with the owner information.

### [Configuration 5]

In the battery unit as in configuration 3,
the first monitoring unit is configured to acquire voltage information of the battery module and current information during energization as the primary monitoring information,
the control unit is configured to calculate deterioration information indicating a degree of deterioration of the battery module as the secondary monitoring information based on the voltage information and the current information, and
at least one of the control unit and the first monitoring unit is configured to, during the primary use of the battery module:
   associate the history information indicative of a history of the deterioration information with the owner information;
   store the associated history information in a storage unit provided in either the control unit or the first monitoring unit or transmit the associated history information to an external device (20) capable of communicating with the control unit; and
   cause the storage unit included in the second monitoring unit to store the history information indicative of the history of the deterioration information without associating the history information with the owner information.

### [Configuration 6]

In the battery unit as in configuration 2,
at least one of the control unit and the first monitoring unit is configured to, during the primary use of the battery module:
determine whether the history information constitutes confidential information after completion of the primary use;
when the history information is determined to be the confidential information, refrain from storing the history information in the storage unit included in the second monitoring unit; and
when the history information is determined not to be the confidential information, cause the storage unit included in the second monitoring unit to store the history information.

### [Configuration 7]

In the battery unit as in any one of configurations 2 to 6,
the second monitoring unit is configured to, in a state where the first monitoring unit and the control unit are detached from the assembly including the battery module and the second monitoring unit, acquire the detection result of the detection unit as the primary monitoring information in place of the first monitoring unit.

### [Configuration 8]

In the battery unit as in any one of configurations 2 to 7,
the assembly including the battery module and the second monitoring unit and allowing the first monitoring unit and the control unit to be detachable has a power supply unit (52) configured to supply power to the second monitoring unit.

### [Configuration 9]

In the battery unit as in configuration 8,
the power supply unit is configured to generate a power supply voltage for operating the second monitoring unit using the battery module as a power supply source.

### [Configuration 10]

In the battery unit as in any one of configurations 2 to 9,
the first monitoring unit and the control unit are mounted on a first substrate (61), the second monitoring unit is mounted on a second substrate (62) different from the first substrate, and the first monitoring unit and the control unit are connected to the second monitoring unit by a signal line (35), and
the first monitoring unit and the control unit are detachable from the assembly including the battery module and the second monitoring unit by disconnecting a connector (63, 64) provided in the signal line.

### [Configuration 11]

The battery unit as in configuration 1 for use in a device that uses the battery unit (10) as a power source, wherein
the control unit (82) is configured to, during a primary use of the battery module:
associate the history information with owner information corresponding to an owner of the device;
store the associated history information in a storage unit (82a) provided in the control unit or transmit the associated history information to an external device (20) capable of communicating with the control unit; and
store the history information in the storage unit (81a) included in the monitoring unit and detachable together with the battery module from the control unit without associating the history information with the owner information.

### [Configuration 12]

The battery unit as in any one of configurations 1 to 11, further comprising a power supply unit configured to generate a power supply voltage for operating the monitoring unit and the control unit, the power supply unit including: a first power supply circuit (91) configured to generate the power supply voltage using power supply from outside the unit; and a second power supply circuit (92) configured to generate the power supply voltage using power supply from the battery module, wherein
during a primary use of the battery module, the monitoring unit and the control unit operate using the first power supply circuit as a power source, and
in a state where the control unit is detached from the assembly including the battery module and the monitoring unit, the monitoring unit operates using the second power supply circuit as a power source in the assembly.

Although the present disclosure has been described based on the embodiments, it is understood that the present disclosure is not limited to the embodiments or structures. The present disclosure also includes various modifications and modifications within the equivalent range. In addition, various combinations and forms, as well as other combinations and forms including only one element, more, or less, are also within the scope and spirit of the present disclosure.

## Claims

1. A battery unit (10) comprising:
a battery module (11);
a monitoring unit (31, 32, 81) configured to acquire, as primary monitoring information, a detection result obtained by a detection unit (41 to 43) configured to detect a state of the battery module; and
a control unit (33, 82) configured to receive the primary monitoring information from the monitoring unit and configured to calculate secondary monitoring information by arithmetic processing based on the primary monitoring information, wherein
the monitoring unit includes a storage unit (32a, 81a) in which history information indicative of a history of at least one of the primary monitoring information and the secondary monitoring information is stored, and
the control unit is configured to be detachable from an assembly (SA, SB) including the battery module and the monitoring unit.

2. The battery unit according to claim 1, wherein
the monitoring unit includes a first monitoring unit (31) and a second monitoring unit (32),
at least the second monitoring unit includes the storage unit (32a),
during primary use of the battery module, the first monitoring unit among the first and second monitoring units is configured to acquire the detection result of the detection unit as the primary monitoring information, the control unit is configured to calculate the secondary monitoring information based on the primary monitoring information from the first monitoring unit, and the second monitoring unit is configured to store the history information in the storage unit included in the second monitoring unit, and
the first monitoring unit and the control unit are configured to be detachable from an assembly (SA) including the battery module and the second monitoring unit.

3. The battery unit according to claim 2, for use in a device that uses the battery unit (10) as a power source, wherein
at least one of the control unit and the first monitoring unit is configured to, during the primary use of the battery module:
associate the history information with owner information corresponding to an owner of the device;
store the associated history information in a storage unit provided in either the control unit or the first monitoring unit or transmit the associated history information to an external device (20) capable of communicating with the control unit; and
cause the storage unit included in the second monitoring unit to store the history information without associating the history information with the owner information.

4. The battery unit according to claim 3, wherein
the first monitoring unit is configured to acquire voltage information of the battery module as the primary monitoring information,
the control unit is configured to calculate charge/discharge information regarding overcharge, overdischarge or rapid charging of the battery module, as the secondary monitoring information, based on the voltage information, and
at least one of the control unit and the first monitoring unit is configured to, during the primary use of the battery module:
associate the history information indicative of a history of the charge/discharge information with the owner information;
store the associated history information in a storage unit provided in either the control unit or the first monitoring unit or transmit the associated history information to an external device (20) capable of communicating with the control unit; and
cause the storage unit included in the second monitoring unit to store the history information indicative of the history of the charge/discharge information without associating the history information with the owner information.

5. The battery unit according to claim 3, wherein
the first monitoring unit is configured to acquire voltage information of the battery module and current information during energization as the primary monitoring information,
the control unit is configured to calculate deterioration information indicating a degree of deterioration of the battery module, as the secondary monitoring information, based on the voltage information and the current information, and
at least one of the control unit and the first monitoring unit is configured to, during the primary use of the battery module:
associate the history information indicative of a history of the deterioration information with the owner information;
store the associated history information in a storage unit provided in either the control unit or the first monitoring unit or transmit the associated history information to an external device (20) capable of communicating with the control unit; and
cause the storage unit included in the second monitoring unit to store the history information indicative of the history of the deterioration information without associating the history information with the owner information.

6. The battery unit according to claim 2, wherein
at least one of the control unit and the first monitoring unit is configured to, during the primary use of the battery module:
determine whether the history information constitutes confidential information after completion of the primary use;
when the history information is determined to be the confidential information, refrain from storing the history information in the storage unit included in the second monitoring unit; and
when the history information is determined not to be the confidential information, cause the storage unit included in the second monitoring unit to store the history information.

7. The battery unit according to any one of claims 2 to 6, wherein
the second monitoring unit is configured to, in a state where the first monitoring unit and the control unit are detached from the assembly including the battery module and the second monitoring unit, acquire the detection result of the detection unit as the primary monitoring information in place of the first monitoring unit.

8. The battery unit according to any one of claims 2 to 6, wherein
the assembly including the battery module and the second monitoring unit and allowing the first monitoring unit and the control unit to be detachable has a power supply unit (52) configured to supply power to the second monitoring unit.

9. The battery unit according to claim 8, wherein
the power supply unit is configured to generate a power supply voltage for operating the second monitoring unit using the battery module as a power supply source.

10. The battery unit according to any one of claims 2 to 6, wherein
the first monitoring unit and the control unit are mounted on a first substrate (61), the second monitoring unit is mounted on a second substrate (62) different from the first substrate, and the first monitoring unit and the control unit are connected to the second monitoring unit by a signal line (35), and
the first monitoring unit and the control unit are configured to be detachable from the assembly including the battery module and the second monitoring unit by disconnecting a connector (63, 64) provided in the signal line.

11. The battery unit according to claim 1, for use in a device that uses the battery unit (10) as a power source, wherein
the control unit (82) is configured to, during a primary use of the battery module:
associate the history information with owner information corresponding to an owner of the device;
store the associated history information in a storage unit (82a) provided in the control unit or transmit the associated history information to an external device (20) capable of communicating with the control unit; and
store the history information in the storage unit (81a) included in the monitoring unit and detachable together with the battery module from the control unit without associating the history information with the owner information.

12. The battery unit according to claim 1, further comprising a power supply unit configured to generate a power supply voltage for operating the monitoring unit and the control unit, the power supply unit including: a first power supply circuit (91) configured to generate the power supply voltage using power supply from outside the unit; and a second power supply circuit (92) configured to generate the power supply voltage using power supply from the battery module, wherein
during a primary use of the battery module, the monitoring unit and the control unit operate using the first power supply circuit as a power source, and
in a state where the control unit is detached from the assembly including the battery module and the monitoring unit, the monitoring unit operates using the second power supply circuit as a power source in the assembly.
